## Europäisches Patentamt

(19) **European Patent Office**

**Office européen des brevets**

(11) Publication number: **0 095 344**
**B1**

(12) **EUROPEAN PATENT SPECIFICATION**

(45) Date of publication of the patent specification:
**12.03.86**

(51) Int. Cl.⁴: **G 01 R 29/24, G 03 G 15/02**

(21) Application number: **83302896.2**

(22) Date of filing: **20.05.83**

(54) Method of monitoring electrostatic charge deposition.

(30) Priority: **20.05.82 GB 8214791**

(43) Date of publication of application:
**30.11.83 Bulletin 83/48**

(45) Publication of the grant of the patent:
**12.03.86 Bulletin 86/11**

(84) Designated Contracting States:
**AT BE CH DE FR GB IT LI LU NL SE**

(56) References cited:
**GB - A - 2 026 708**
**US - A - 3 908 164**
**US - A - 3 934 141**
**US - A - 4 248 519**

**INTERNATIONAL ELECTRONICS, vol. 54, no. 4, February 24, 1981, pages 170-171, New York, US, PH.R. GANTT: "Charge integrator measures low-level currents"**

(73) Proprietor: **COMTECH RESEARCH UNIT LIMITED, Bank of Bermuda Building, Hamilton 5-31 (BM)**

(72) Inventor: **Humberstone, Victor Carey, 22 Greenfield Close, Stapleford Cambridge (GB)**

(74) Representative: **Abrams, Michael John et al, HASELTINE LAKE & CO. Hazlitt House 28 Southampton Buildings Chancery Lane, London WC2A 1AT (GB)**

ACTORUM AG

## Description

This invention relates to monitoring the state of charge of an electrophotographic film.

In many applications of electrophotography an essential part of the process is the placing of an electrostatic charge on a surface, for example the surface of a photoconductive layer which overlies an electrode layer. The quantity of charge so placed may be critical and a means of monitoring is required.

Hitherto, methods and devices for monitoring the state of charge of a dielectric surface have been concerned essentially with the charging process used in the course of a photocopying operation such as xerography. For example, U.S. Patent No. 3908164 describes a circuit for obtaining a true measurement of the charging current supplied by a high-frequency A.C. corona discharge device to a receiving surface, e.g. a photoreceptor drum carried by a grounded metal plate. The circuit is a bridge circuit with the A.C. corona discharge device in one arm of the bridge and a resistor connected in the current return path from the corona discharge device to the power supply in a second arm of the bridge. The remaining arms of the bridge include a capacitor and a resistor connected in series with each other across the source to complete the bridge and provide a signal to compensate for reactive current through the corona device. The theoretical basis for the circuitry and the technique for using it are described in detail.

In electrophotography, it is not always possible or desirable to measure directly the charge applied to the photoconductive film surface. The environment in which the film is used may also make it difficult to adopt indirect measuring methods.

In the present invention, no attempt is made to measure directly the charge deposited on the surface. Instead, there is utilised the principle that a substantially equal and opposite charge will flow from earth onto the underlying earthed electrode. That charge may be measured by several techniques and the indication so obtained may be used to control a corotron or other device which is supplying the charge.

According to one aspect of the present invention, there is provided a method of monitoring the deposition of electrostatic charge on one surface of an electrophotographic film of the type having a photoconductive layer (the charge-receiving layer), an electrode layer directly beneath said photoconductive layer and a substrate supporting the other layers, characterised in that the method comprises connecting an electrical circuit between earth and said electrode layer and measuring the charge which is induced in said electrode layer and/or measuring the resultant potential difference between said electrode layer and earth.

According to a second aspect of the present invention, there is provided a method of monitoring the deposition of electrostatic charge on one surface of an electrographic sheet film during a charging operation using a corona discharge device, characterised in that the method comprises monitoring the electrostatic charge induced on the surface of the film remote from the corona discharge device by the steps of:

a) bringing an electrode into contact with the surface of the film remote from the corona discharge device;

b) connecting between said electrode and earth an electrical circuit comprising: i) a differential amplifier one input to which is connected to said electrode and the other input to which is connected to earth; ii) a source of reference potential; and iii) a voltage comparator one input to which is connected to the output of said differential amplifier and the other input to which is connected to said reference source, and

c) monitoring the output from said comparator.

The invention will now be described in detail with the aid of Fig. I. A corotron 1 progressively charges the surface 2 of the active structure 3 of an electrophotographic film material. The material also includes an electrode layer 4, which in many materials is so thin as to be transparent. Layers 3 and 4 are supported on a mechanically robust layer 5. As surface 2 accepts charge a substantially equal and opposite charge is drawn onto electrode 4 *via* the measuring circuit 6 from earth 7 and through connection 8.

Thus by making measurements only on layer 4, which is accessible, it is possible to monitor the electrical condition of surface 2, which is critical but inconvenient to measure directly.

There are many possible arrangements for the measuring circuit 6. For ease of understanding two possible circuits will now be described with reference to Fig. II and III.

The circuit of Fig. II depends on the characteristic that as charge accumulates on surface 2, its potential changes to become nearer to that of the charge source (the corotron). Because of the decreasing potential difference between source and receiver, the current flow also drops. By calibration the current flow when the surface 2 is correctly charged can be determined. But for the existence of amplifier 9, the current flowing through connection 8 to electrode 4 would be drawn through resistor 10. However, in the well-known action of a virtual earth amplifier, almost all the current into connection 8 flows through resistor 11. Whilst the current flow is large, the potential at circuit node 12 is large. As the current falls the voltage at 12 falls and at some point becomes lesser than, instead of greater than the voltage supplied by reference source 13. When that occurs the output of the comparator 14 changes by a large amount. This change is used to control the corotron.

Fig. III shows another measuring circuit usable with this invention. Current flowing into electrode 4 through lead 8 is supplied *via* capacitor 15. As the current flows the voltage at circuit node 16 rises continuously. That voltage is proportional to the integral with respect to time of the current flowing through 8, i.e. to the total charge on electrode 4, which as we have seen is substantially equal to the charge on surface 2. When the voltage at node 16 rises above the voltage at the reference source 17, the output of comparator 18 changes abruptly. This change is used to control the corotron. Contact 19 is used to zero the integrator for a new cycle.

Other possible circuit arrangements include the use of a Schmidt trigger in place of a comparator in either circuit, or, using the current to voltage amplifier of Fig. II, using an analogue to digital converter and a digital integrator.

The details of the materials forming layers 3, 4 and 5 are not the subject of this invention but, for example, the material may be of the class of materials known as TEP (transparent electrophotographic) such as are commercially available from Kodak or from James River Graphics; equally the invention may be used with migration photography materials such as XDM from Xerox Corporation.

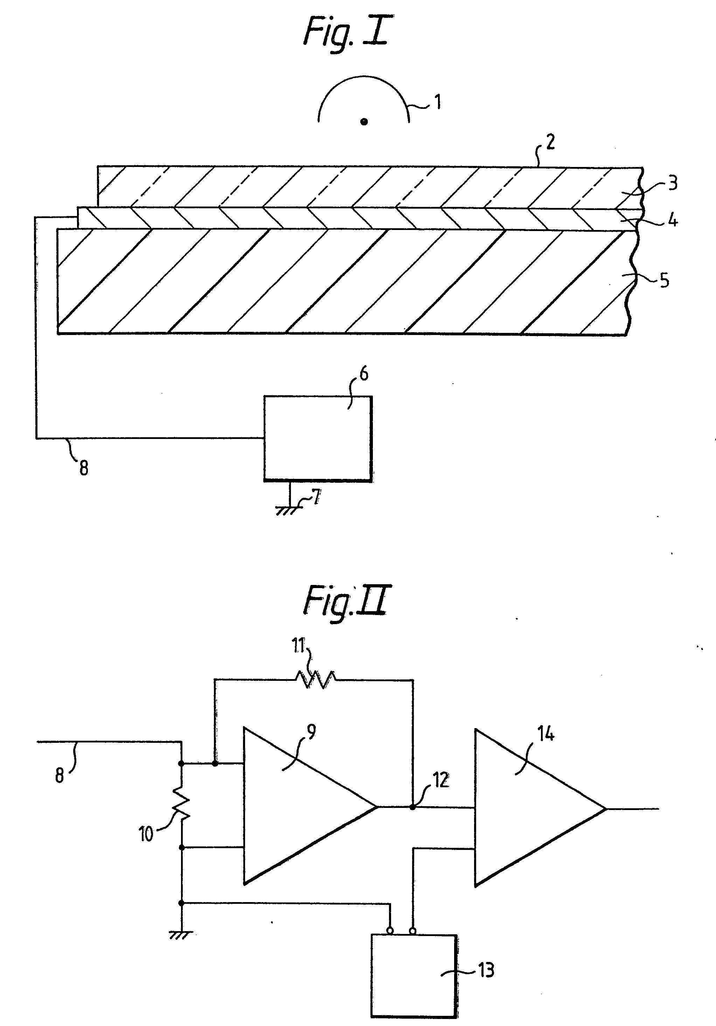

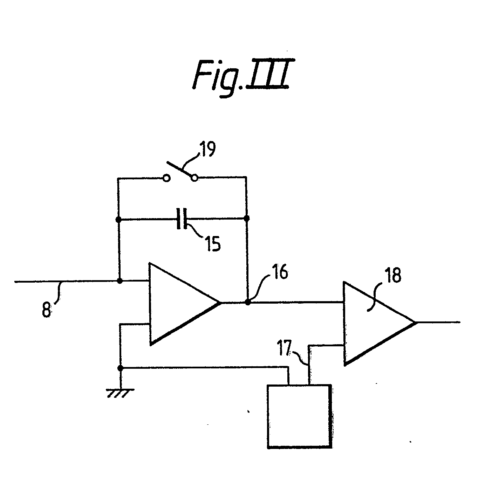

## Claims

1. A method of monitoring the deposition of electrostatic charge on one surface (2) of an electrophotographic film of the type having a photoconductive layer (3) (the charge-receiving layer), an electrode layer (4) directly beneath said photoconductive layer (3) and a substrate (5) supporting the other layers, characterised in that the method comprises connecting an electrical circuit (8, 9, 10, 11, 12, 13, 14; 8, 9, 13, 15, 16, 17, 18, 19) between earth and said electrode layer (4), and measuring the charge which is induced in said electrode layer (4) and/or measuring the resultant potential difference between said electrode layer (4) and earth.

2. A method according to Claim 1, wherein the output from said electrical circuit is used to control a device (1) which is applying an electrostatic charge to said surface (2).

3. A method according to any one of Claims 1 or 2, wherein said electrical circuit comprises a virtual earth amplifier (9, 10, 11).

4. A method according to any one of Claims 1, 2 or 3, wherein the electrical circuit comprises an amplifier (9) connected between said electrode layer (4) and earth, a capacitor (15) connected across the output from the amplifier (9) and the connection (8) between the amplifier (9) and said electrode layer (4), and a comparator (18) one input of which is connected to the output of said amplifier and the other input (17) of which is connected to a reference source (13).

5. A method according to Claim 4, which further comprises a switch (19) in parallel with said capacitor (15).

6. A method of monitoring the deposition of electrostatic charge on one surface (2) of an electrographic sheet film (3) during a charging operation using a corona discharge device (1), characterised in that the method comprises monitoring the electrostatic charge induced on the surface of the film (3) remote from the corona discharge device (1) by the steps of:

a) bringing an electrode (4) into contact with the surface of the film (3) remote from the corona discharge device (1);

b) connecting between said electrode (4) and earth an electrical circuit comprising: i) a differential amplifier (9) one input to which is connected to said electrode (4) and the other input to which is connected to earth; ii) a source (13) of reference potential, and iii) a voltage comparator (14) one input to which is connected to the output (12) of said differential amplifier (9) and the other input to which is connected to said reference source (13), and

c) monitoring the output from said comparator.

7. A method according to any preceding claim, wherein the electrophotographic film is a transparent electrophotographic material (TEP) or an image migration material.

## Patentansprüche

1. Verfahren zum Überwachen der Abscheidung einer elektrostatischen Ladung auf einer Oberfläche (2) eines eine photoleitende Schicht (3) (die Ladungsempfangsschicht), eine Elektrodenschicht (4) unmittelbar unterhalb dieser photoleitenden Schicht (3) und ein diese anderen Schichten abstützendes Substrat (5) aufweisenden elektrophotographischen Films, dadurch gekennzeichnet, dass zwischen Erde und der Elektrodenschicht (4) ein elektrischer Schaltkreis (8, 9, 10, 11, 12, 13, 14; 8, 9, 13, 15, 16, 17, 18, 19) geschaltet und die in dieser Elektrodenschicht (4) induzierte Ladung und/oder die erhaltene Potentialdifferenz zwischen der Elektrodenschicht (4) und Erde gemessen wird.

2. Verfahren nach Anspruch 1, worin die Ausgangsgrösse aus diesem elektrischen Schaltkreis zum Steuern einer Vorrichtung (1) verwendet wird, welche auf die erwähnte Oberfläche (2) eine elektrostatische Ladung aufbringt.

3. Verfahren nach einem der Ansprüche 1 oder 2, worin der erwähnte elektrische Schaltkreis einen Scheinerdungsverstärker (9, 10, 11) aufweist.

4. Verfahren nach einem der Ansprüche 1, 2 oder 3, worin der elektrische Schaltkreis einen zwischen die Elektrodenschicht (4) und Erde geschalteten Verstärker (9), eine den Ausgang des Verstärkers (9) und die Leitung (8) zwischen dem Verstärker (9) und der Elektrodenschicht (4) überbrückende Kapazität (15) und einen Komparator (18) aufweist, von welchem ein Eingang mit dem Ausgang des erwähnten Verstärkers und der andere Eingang (17) mit einer Bezugsgrössenquelle (13) verbunden ist.

5. Verfahren nach Anspruch 4, bei welchem weiters ein Schalter (19) parallel zur erwähnten Kapazität (15) geschaltet ist.

6. Verfahren zum Überwachen der Abscheidung einer elektrostatischen Ladung auf einer Oberfläche (2) eines Films (3) aus einer elektrographischen Bahn während des Beladens unter Verwendung einer Sprühentladungseinrichtung (1), dadurch gekennzeichnet, dass die auf der von der Sprühentladungseinrichtung (1) entfernten Oberfläche des Films (3) induzierte elektrostatische Ladung dadurch gemessen wird, dass

a) eine Elektrode (4) mit der von der Sprühentladungseinrichtung (1) entfernten Oberfläche des Films (3) in Berührung gebracht wird,

b) zwischen diese Elektrode (4) und Erde ein elektrischer Schaltkreis geschaltet wird, welcher i) einen Differenzverstärker (9), von welchem ein Eingang an die Elektrode (4) und der andere Eingang an Erde gelegt ist, ii) eine Bezugsspannungsquelle (13), und iii) einen Spannungskomparator (14), von welchem ein Eingang an den Ausgang (12) des Differenzverstärkers (9) und der andere Eingang an die Bezugsspannungsquelle (13) gelegt ist, aufweist, und

c) der Ausgang des Spannungskomparators überwacht wird.

7. Verfahren nach irgendeinem der vorhergehenden Ansprüche, worin der elektrophotographische Film ein transparentes elektrophotographisches Material (TEP) oder ein Bildmigrationsmaterial ist.

## Revendications

1. Procédé de contrôle du dépôt d'une charge électrostatique sur une surface (2) d'une pellicule électrophotographique du type comportant une couche photoconductrice (3) ou couche de réception de charge, une couche d'électrode (4) directement au-dessous de ladite couche photoconductrice (3) et un substrat (5) supportant les autres couches, procédé caractérisé en ce qu'il consiste à connecter un circuit électrique (8, 9, 10, 11, 12, 13, 14; 8, 9, 13, 15, 16, 17, 18, 19) entre la masse et ladite couche d'électrode (4) et à mesurer la charge qui est produite dans ladite couche d'électrode (4) et/ou à mesurer la différence de potentiel résultante entre ladite couche d'électrode (4) et la masse.

2. Procédé selon la revendication 1, dans lequel la sortie dudit circuit électrique est utilisée pour commander un dispositif (1) qui applique une charge électrostatique à ladite surface (2).

3. Procédé selon l'une des revendications 1 ou 2, dans lequel ledit circuit électrique comporte un amplificateur à masse virtuelle (9, 10, 11).

4. Procédé selon l'une des revendications 1, 2 ou 3, dans lequel le circuit électrique comporte un amplificateur (9) connecté entre ladite couche d'électrode (4) et la masse, un condensateur (15) connecté entre la sortie de l'amplificateur (9) et la connexion (8) entre l'amplificateur (9) et ladite couche d'électrode (4) et un comparateur (18) dont une entrée est connectée à la sortie dudit amplificateur et dont l'autre entrée (17) est connectée à une source de référence (13).

5. Procédé selon la revendication 4, comportant en outre un commutateur (19) en parallèle avec ledit condensateur (15).

6. Procédé de contrôle du dépôt d'une charge électrostatique sur une surface (2) d'une pellicule de feuille électrographique (3) pendant une opération de charge en utilisant un dispositif de décharge à effet couronne (1), procédé caractérisé en ce qu'il consiste à contrôler la charge électrostatique produite à la surface de la pellicule (3) opposée au dispositif de décharge à effet couronne (1) par les opérations:

a) de mise en contact d'une électrode (4) avec la surface de la pellicule (3) opposée au dispositif de décharge à effet couronne (1);

b) de connexion entre ladite électrode (4) et la masse d'un circuit électrique comportant: i) un amplificateur différentiel (9) dont une entrée est connectée à ladite électrode (4) et dont l'autre entrée est connectée à la masse; ii) une source (13) de potentiel de référence, et iii) un comparateur de tension (14) dont une entrée est connectée à la sortie (12) dudit amplificateur différentiel (9), et dont l'autre entrée est connectée à ladite source de référence (13), et

c) de contrôle de la sortie dudit comparateur.

7. Procédé selon l'une des revendications précédentes, dans lequel la pellicule électrophotographique est une matière électrophotographique transparente (TEP) ou une matière à migration d'image.

*Fig. I*

*Fig. II*

# Fig.III